# FASCICULE DE BREVET EUROPEEN

(11) **EP 2 158 577 B1**
(45) Date de publication et mention de la délivrance du brevet: **04.11.2015**
(21) Numéro de dépôt: 08805889.6
(22) Date de dépôt: 29.05.2008
(51) Int. Cl.: G07C 5/08, G06F 17/50

(54) **PROCÉDÉ ET DISPOSITIF D'ACQUISITION, ENREGISTREMENT ET EXPLOITATION DE DONNÉES CAPTÉES DANS UN AÉRONEF**
VERFAHREN UND VORRICHTUNG ZUR ERFASSUNG, AUFZEICHNUNG UND VERWENDUNG VON IN EINEM FLUGZEUG ERFASSTEN DATEN
METHOD AND DEVICE FOR ACQUIRING, RECORDING AND UTILIZING DATA CAPTURED IN AN AIRCRAFT

(30) Priorité: 05.06.2007 FR 0704019
(43) Date de publication de la demande: 03.03.2010
(73) Titulaire: AIRBUS OPERATIONS, 31060 Toulouse (FR)
(72) Inventeur: VIALATTE, Jean-Luc, F-31300 Toulouse (FR); CALVET, Sophie, F-31470 Fonsorbes (FR)
(74) Mandataire: Santarelli
(86) Numéro de dépôt international: PCT/FR2008/050946
(87) Numéro de publication internationale: WO 2008/152310

(56) Documents cités:
- FR-A- 2 883 088
- US-A1- 2004 260 777
- US-A1- 2005 258 942
- US-A1- 2005 267 656
- US-A1- 2007 112 488

## Description

La présente invention concerne un procédé et un dispositif d'acquisition et d'enregistrement de données captées dans un aéronef. Elle concerne, en particulier, les installations d'essais en vol permettant l'enregistrement et la visualisation de vidéo, audio, données graphiques et, plus généralement, de tout type de données numériques.

Les installations d'essais en vol sont, de manière connue, chargées d'enregistrer les sources vidéo, par exemple SDI (acronyme de « Serial Digital Interface » pour interface numérique série), notamment des caméras d'essais ou des vidéos provenant de systèmes de l'avion, et certaines données représentant des paramètres de l'avion associées. Les systèmes d'enregistrement sont des systèmes propriétaires qui ont nécessité des adaptations aux besoins des avions d'essais. Ils stockent les données sur des cassettes à bande magnétique. En fonction des époques et de la technologie alors disponible sur le marché, différents types de format d'enregistrement vidéo et d'enregistreurs ont été utilisés.

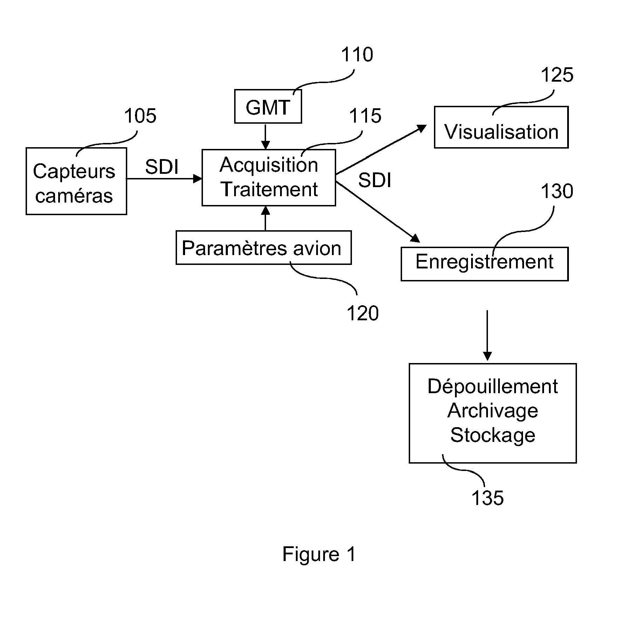

La figure 1 illustre, schématiquement, les blocs fonctionnels d'une chaîne de mesure vidéo de l'art antérieur. Dans un tel système, le besoin de dater et d'associer des données de paramètres de l'avion à la vidéo, ainsi que le besoin d'enregistrer le plus de voies possibles, a conduit à réaliser des adaptations du matériel professionnel disponible sur le marché en détournant autant que possible certaines fonctions et en faisant des compromis qualitatifs et quantitatifs.

Comme on le voit en figure 1, la vidéo est obtenue par les capteurs caméras 105 et est ensuite traitée par des moyens de traitement 115. Un GMT (acronyme de « Greenwich mean time » pour temps moyen de Greenwich) 110, c'est-à-dire un horodatage basé sur une heure universelle lui est appliqué afin de connaître avec précision le déroulement de l'essai et de relier la vidéo à toutes les autres données obtenues en parallèle, notamment les paramètres de l'avion 120. Pour certains avions, les paramètres de l'avion sont calculés par un calculateur de bord (non représenté) et codés. Les données correspondantes sont limitées en nombre de paramètres et en fréquence de rafraîchissement. En sortie des moyens de traitement 115, le signal est, par exemple, transporté selon la norme SDI « SMPTE 259 ». Le débit d'une telle connexion est fixé à 270 Mbps.

Le signal est visualisé sur un écran de visualisation 125 pendant l'essai lui-même. On note que des convertisseurs de formats (non représentés) sont nécessaires pour la visualisation du signal vidéo SDI. Par ailleurs, la vidéo et les métadonnées, c'est-à-dire les paramètres, identifiants d'avion, de vol et de matériels utilisés et l'heure, sont enregistrées sur cassettes 130 en vue de leur dépouillement, archivage et/ou stockage par des moyens au sol 135. Le format d'enregistrement utilisé est imposé par l'enregistreur utilisé. Ce format est uniquement destiné aux professionnels. En outre, des données avion (type, n°...) sont rajoutées pour faciliter la classification et l'archivage. Ces renseignements sont complétés sur la cassette. On obtient ainsi un en-tête pour chaque cassette.

Au sol, les cassettes obtenues sont ensuite dépouillées par des spécialistes sur un banc d'exploitation. L'exploitation des bandes magnétiques se fait de façon linéaire, la cassette devant être parcourue pour rechercher la séquence souhaitée. De plus, les paramètres de l'avion étant enregistrés de manière partielle, une connexion entre le banc d'exploitation et une base de données est nécessaire.

Comme on le comprend à la lecture de ce qui précède, l'architecture de bord de l'IEV (acronyme de « Installation d'Essais en Vol ») vidéo actuelle est donc relativement complexe, en raison du support utilisé, c'est-à-dire des bandes magnétiques. Les flux (vidéo, audio et paramètres de l'avion) sont, en effet, enregistrés sur des cassettes.

Cet état de l'art présente de nombreux inconvénients :
- un magnétoscope ne permet d'enregistrer que des flux vidéo de définition standard, aussi appelés « SD ». Pour pouvoir enregistrer des flux vidéo de haute définition, aussi appelés « HD », il faudrait utiliser des magnétoscopes de type HDCam, dont le surcoût est conséquent. Pour pouvoir enregistrer des pages graphiques de type ASVI (acronyme de « Avionics Serial Video Interface » pour interface vidéo série d'avionique), concernant les instruments du cockpit, ou VGA (acronyme de « Video Graphics Array » pour matrice vidéo graphique), il faudrait ajouter des modules permettant de convertir ces signaux en un signal vidéo SD ou HD ;
- la datation des images sur un magnétoscope se fait à partir d'un code temporel, appelé « timecode », fourni par l'intermédiaire d'un signal AES (acronyme de « Audio Engineering Society » pour société d'ingénierie audio, une organisation de normalisation qui définit une structure de signal numérique pour entrée audio professionnelle). Un module matériel permettant de convertir le temps avion en timecode AES doit donc être développé spécifiquement pour pouvoir dater les images à partir du temps avion et
- aucun système n'est prévu sur un magnétoscope pour enregistrer des paramètres dynamiques. Un module matériel permettant de coder les paramètres avions dans une piste audio doit donc être développé pour permettre l'enregistrement de ces paramètres avions. Un autre module matériel doit aussi être développé pour la lecture de ces paramètres lors de l'exploitation au sol.
- les cassettes constituent un support linéaire. Ceci signifie que les différents flux (audio, vidéo et paramètres) doivent être synchronisés lors de l'acquisition. Ceci pose problème car les temps de transmission de ces différents flux sont différents.

US2005/0267656 décrit un système d'acquisition et d'enregistrement de données d'aéronef.

La présente invention vise à remédier à tout ou partie de ces inconvénients. En particulier, la présente invention vise à résoudre tout ou partie des problèmes indiqués ci-dessous.

Un premier problème consiste à associer et synchroniser de façon simple et sans limitation, les métadonnées, les données vidéo, les données audio et les pistes de temps de chaque flux. Les flux vidéo doivent être acquis sans perte d'information, c'est-à-dire en résolution et fréquences natives, et stockés de manière compressée ou non compressée. En particulier, il s'agit d'enregistrer les différents flux sur un même support, en pratique au moins un disque dur, mais, préférentiellement dans différents fichiers, ce qui présente l'avantage qu'il n'est pas nécessaire de synchroniser les flux à l'acquisition.

Un deuxième problème concerne l'obsolescence très prochaine du support d'enregistrement jusqu'ici utilisé, la cassette à bande magnétique, et du matériel d'enregistrement et de relecture. Le problème est de trouver un format d'échange répondant non seulement aux contraintes de l'embarqué mais aussi adapté aux contraintes rencontrées au sol, notamment l'archivage automatique et l'exploitation simple et rapide des données acquises. Préférentiellement, on vise à uniformiser les infrastructures d'archivage pour la vidéo et pour les données avions déjà enregistrées sur disque dur.

Un troisième problème consiste à permettre d'enregistrer tous les types de formats. En effet, de nouveaux formats apparaissent, notamment en haute définition, en sortie de calculateurs, par exemple en ARINC 818 (acronyme de « Aeronautical Radio, Incorporated », marque déposée, pour société de radio aéronautique, dont le standard 818 concerne un bus vidéo numérique avionique), VGA, des données décrivant l'essai à associer, des fonctions de pre-trigger, c'est-à-dire de pré-déclenchement, et de rejeu (en anglais « play » ou « replay »). De plus, de nouveaux algorithmes de compression puissants et du matériel permettant des débits importants apparaissent. L'invention vise donc à déterminer une architecture système bord non spécifique à la vidéo ainsi qu'un format de fichier permettant d'acquérir, compresser, synchroniser, stocker et rejouer et exploiter différents flux de données, vidéo, audio, paramètres, graphiques, sans limitation qualitative et quantitative.

La présente invention vise, en particulier, à résoudre tout ou partie de ces problèmes. A cet effet, selon premier aspect, la présente invention vise un dispositif d'acquisition et d'enregistrement de données captées dans un aéronef, comportant :
- une pluralité de sources de flux de données à enregistrer,
- au moins une source de valeurs de paramètres d'enregistrement datés et
- des moyens d'enregistrement des données issues des flux de données et des valeurs de paramètre, sur au moins un support d'information non volatile,
caractérisé en ce que les moyens d'enregistrement sont adaptés à stocker dans des fichiers séparés les données des différents flux de données, associées avec des dites valeurs de paramètres d'enregistrement datées, chaque donnée de flux de données étant enregistrée en association avec le temps universel de son acquisition.

L'invention fournit ainsi une architecture de système à bord non spécifique à la vidéo ainsi qu'un format de fichier permettant d'acquérir, compresser, synchroniser, stocker et rejouer et exploiter différents flux de données, vidéo, audio, paramètres, graphiques, sans limitation qualitative et quantitative.

De plus, l'architecture proposée est une architecture modulaire, les différents flux audio/vidéo issus de différentes sources étant acquis par plusieurs processus différents, qui permet d'ajuster le dimensionnement (le nombre de serveurs d'acquisition et de disques durs de stockage) au nombre de voies enregistrées et facilite l'ajout de nouvelles fonctions.

Grâce à ces dispositions, il n'est pas nécessaire de synchroniser les flux lors de l'acquisition.

Enregistrer les flux dans plusieurs fichiers différents présente les avantages suivants :
- à bord, les fichiers sont générés par plusieurs processus différents et peuvent être enregistrés sur plusieurs disques durs différents et
- au sol, le stockage des différents flux dans des fichiers séparés permet de limiter la taille des fichiers, et la quantité de données à traiter en fonction des requêtes, seuls les fichiers contenant les flux demandés doivent par exemple être remis « nearline ».

L'invention propose une architecture matérielle conçue autour d'un serveur simple (qui peut être unique), associée à un format de fichier adapté aux contraintes de l'aéronautique et plus particulièrement des essais en vol.

Le format de fichier proposé permet d'enregistrer tous les types de données avec la possibilité de les synchroniser, et faciliter l'exploitation, notamment par un accès aléatoire aux données à partir d'un temps absolu, par un renseignement automatique de base de données pour faciliter la recherche et par une sécurisation des données.

De plus, l'architecture proposée est une architecture modulaire, les différents flux audio/vidéo issus de différentes sources étant acquis par plusieurs processus différents, qui permet d'ajuster le dimensionnement (le nombre de serveurs d'acquisition et de disques durs de stockage) au nombre de voies enregistrées et facilite l'ajout de nouvelles fonctions.

Le but final est d'obtenir des « workflows » optimisés (au sol et en vol) prenant en compte les contraintes métier des essais en vol. On rappelle ici qu'un « workflow » est un flux d'informations au sein d'une organisation, comme par exemple la transmission automatique de documents entre des personnes. On appelle « workflow » (littéralement, en français « flux de travail ») la modélisation et la gestion informatique de l'ensemble des tâches à accomplir et des différents acteurs impliqués dans la réalisation d'un processus métier (aussi appelé processus opérationnel ou bien procédure d'entreprise). Le terme de « workflow » pourrait donc être traduit en français par « gestion électronique des processus métier ». De façon plus pratique, le « workflow » décrit le circuit de validation, les tâches à accomplir entre les différents acteurs d'un processus, les délais, les modes de validation, et fournit à chacun des acteurs les informations nécessaires pour la réalisation de sa tâche. Il permet généralement un suivi et identifie les acteurs en précisant leur rôle et la manière de le remplir au mieux. Le moteur de « workflow » est le dispositif logiciel permettant d'exécuter une ou plusieurs définitions de « workflow ». Par abus de langage, on peut appeler ce dispositif logiciel tout simplement « workflow ».

La gestion des contenus (données, vidéo, audio, graphismes) dans un environnement informatisé sans cassettes permet :
- de limiter les coûts et
- de faciliter l'exploitation (rationalisation de l'archivage des données, accès facile et rapide aux données).

Cette solution est portée par une architecture simple autour d'un serveur central, mais aussi adaptable tant au niveau formats d'entrées que taux de compression.

Selon des caractéristiques particulières, les moyens d'enregistrement comportent un moyen de génération de fichiers de synthèse générés au fur et à mesure de l'enregistrement de fichiers représentatifs de données provenant de différentes sources de données, le fichier de synthèse permettant de référencer et relire, de façon synchrone, ces fichiers et contenant des références externes pointant vers chacun les fichiers représentatifs de données provenant des sources de données. Ce fichier de synthèse permet la relecture synchrone des fichiers en associant plusieurs flux datés, contenus dans plusieurs fichiers.

Selon des caractéristiques particulières, les moyens d'enregistrement sont adaptés à enregistrer de manière dynamique, dans au moins un fichier, les valeurs de paramètres.

Selon des caractéristiques particulières, les moyens d'enregistrement sont adaptés à enregistrer des descripteurs des paramètres, ainsi que des données relatives à l'essai par le biais d'une structure de données universelle.

Par exemple, les données relatives à l'essai sont le type d'essai, le numéro d'essai, le type d'avion, le numéro d'avion et le numéro de vol.

Selon des caractéristiques particulières, les moyens d'enregistrement sont adaptés à enregistrer chaque donnée de flux de données en association avec le temps universel de son acquisition.

On permet ainsi d'enregistrer tous les types de données avec la possibilité de les synchroniser, et on facilite l'exploitation, notamment par un accès aléatoire aux données à partir d'un temps universel.

Grâce à chacune de ces dispositions, on limite l'espace mémoire nécessaire au stockage des données.

Selon des caractéristiques particulières, le dispositif objet de la présente invention, tel que succinctement exposé ci-dessus, comporte un moyen de lecture adapté à générer un fichier de synthèse pour au moins une diffusion de données enregistrées provenant des flux de données. Le fichier de synthèse permettant de référencer et relire, de façon synchrone, les fichiers contenant des données à diffuser, et contenant des références externes pointant vers chacun les fichiers représentatifs de données à diffuser.

Ce fichier de synthèse indique quels flux doivent être diffusés. Ce mécanisme permet d'enregistrer et d'exploiter les flux dans des fichiers différents.

Selon des caractéristiques particulières, le dispositif objet de la présente invention, tel que succinctement exposé ci-dessus, comporte un moyen de routage des données issues des sources vers des moyens d'enregistrement, les moyens d'enregistrement comportant un moyen de datation adapté à compenser les latences de transmission induites par le moyen de routage.

La datation est ainsi très précise.

Selon des caractéristiques particulières, les moyens d'enregistrement sont adaptés à mettre en forme les données issues des sources de données sous forme de fichiers au format MXF (acronyme de « Material exchange Format » pour format d'échange de matériel).

En ce qui concerne les avantages du format MXF relatifs à sa structure logique, on peut citer celui de la structure logique des fichiers au format MXF, qui est indépendante de leur structure physique. Il est donc possible d'organiser et synchroniser les différents flux et les métadonnées entre eux quels que soient leurs types et leurs emplacements.

Ce format offre des mécanismes répondant aux contraintes de l'IEV, notamment :
- la gestion du mode fichier et des différents modes streaming,
- le support des références externes,
- la synchronisation d'un nombre arbitraire de flux de types différents,
- un mécanisme générique pour l'accès aléatoire et
- une gestion des métadonnées très évoluée : gestion des métadonnées statiques et dynamiques, gestion de la portée des métadonnées, « frameworks » de métadonnées normalisées couvrant de large besoins, possibilité de définir des « frameworks » de métadonnées propriétaires.

Selon des caractéristiques particulières, les flux de données sont datés au moment de l'acquisition en utilisant une horloge interne synchronisée sur l'horloge de l'aéronef. Par exemple, une mise à l'heure de l'horloge interne peut être faite par un serveur NTP externe, ou un convertisseur GMT/Timecode AES à partir d'une entrée timecode AES. Des tables d'index permettent alors de retrouver l'image associée à ce code temporel. Ce mécanisme permet d'assurer une lecture synchrone des flux de données enregistrées, même lorsqu'elles n'utilisent pas la même base de temps.

Selon des caractéristiques particulières, les moyens d'enregistrement comportent des moyens d'emballage de chaque flux de données provenant d'une source de flux de données, dans un fichier qui contient des métadonnées statiques identifiant un aéronef, un essai en vol et ladite source de données, les données du flux de données et des informations représentatives de l'instant de capture desdites données.

Selon des caractéristiques particulières, le dispositif objet de la présente invention, tel que succinctement exposé ci-dessus, comporte une mémoire tampon dans laquelle, lorsque l'enregistrement n'est pas activé, les flux de données sont stockés et conservés pendant une durée prédéterminée et lorsque l'enregistrement est démarré, au moins une partie des données mémorisées temporairement est enregistrée.

Selon des caractéristiques particulières, les flux de données provenant des sources de flux de données sont divisés en segments temporels de durée fixe, les moyens d'enregistrement enregistrant pour chaque segment temporel et chaque paramètre, la valeur la plus récente du paramètre disponible pendant ce segment temporel.

Les segments temporels ainsi générés sont, au fur et à mesure, emballés dans un fichier qui contient des métadonnées statiques décrivant l'avion et l'essai, ainsi que les différents paramètres acquis, les métadonnées dynamiques, dans lesquelles sont enregistrées les valeurs et les dates d'acquisition des paramètres retenues pour chaque segment temporel.

On permet ainsi la réorganisation temporelle des paramètres de manière à pouvoir les stocker et les exploiter de la même façon qu'un flux audio/vidéo.

Selon des caractéristiques particulières, les moyens d'enregistrement sont adaptés à enregistrer des fichiers de métadonnées descriptives contenant des valeurs de paramètres répartis dans des segments de durée fixe en fonction de leur date d'acquisition, une seule valeur de paramètre étant enregistrée par paramètre et par segment.

Selon des caractéristiques particulières, les moyens d'enregistrement sont adaptés à diviser les enregistrements en séquences continues, sans interruptions, et homogènes, sans changement de configuration, un nouveau répertoire comportant des nouveaux fichiers pour chaque nouvelle séquence étant généré à chaque fois que l'enregistrement est redémarré ou reconfiguré.

Selon des caractéristiques particulières, les moyens d'enregistrement sont adaptés à stocker les mêmes données avec plusieurs taux et algorithmes de compression différents.

Selon des caractéristiques particulières, le dispositif objet de la présente invention, tel que succinctement exposé ci-dessus, les moyens d'enregistrement sont adaptés, lors d'un essai en vol, à stocker les données en mode « streaming acquisition », mode d'enregistrement dans lequel le fichier est divisé en plusieurs partitions contenant les données d'au moins un flux de données suivies d'un bloc d'information permettant de relire lesdites données d'un flux de données.

Ce mode d'enregistrement est utilisé lorsque les fichiers sont acquis sur un support linéaire (bande), ou lorsque l'acquisition risque d'être interrompue brutalement. Seuls les flux situés après le dernier bloc d'informations lisible ne peuvent être facilement décodés. Ainsi, à bord, les fichiers sont acquis en mode « streaming acquisition », pour qu'ils puissent être utilisés même s'ils n'ont pas été fermés correctement. Ils sont divisés en plusieurs partitions qui correspondent à une durée prédéterminée. Ainsi, en cas de crash, seuls les flux situés dans la dernière partition ne peuvent être facilement décodés.

Selon des caractéristiques particulières, les moyens d'enregistrement sont adaptés, au sol, à convertir les données enregistrées pour les enregistrer en mode « fichier », dans lequel le fichier est divisé en une pluralité de blocs, un en-tête et/ou un pied de fichier contenant les informations permettant de relire le fichier et un corps de fichier contenant les données issues des flux de données.

Ce mode d'enregistrement est plus adapté aux fichiers stockés sur un support permettant l'accès aléatoire (disque dur ou disque compact).

Selon des caractéristiques particulières, le dispositif objet de la présente invention, tel que succinctement exposé ci-dessus, comporte des moyens d'indexation adaptés à générer une table d'index qui indique où se trouvent les différentes images enregistrées.

Cette table permet donc d'accéder aléatoirement à une image pour un flux et un instant donné.

Selon des caractéristiques particulières, les moyens d'enregistrement sont adaptés à conserver au moins un flux de données sous sa forme brute, sans compression.

Selon des caractéristiques particulières, les moyens d'enregistrement sont adaptés à définir des métadonnées descriptives permettant d'agrémenter chaque fichier avec des informations destinées à l'utilisateur, organisées sous forme de « framework ».

Selon des caractéristiques particulières, les moyens d'enregistrement sont adaptés à enregistrer des fichiers de métadonnées descriptives statiques comportant des listes de jeux de métadonnées décrivant des valeurs de paramètres.

Selon des caractéristiques particulières, les moyens d'enregistrement sont adaptés à fournir des données enregistrées, sous forme de rejeu d'un ou plusieurs flux de données synchronisés.

Selon un deuxième aspect, la présente invention vise un procédé d'acquisition et d'enregistrement de données captées dans un aéronef comportant une pluralité de sources de flux de données à enregistrer, au moins une source de valeurs de paramètres d'enregistrement datés et des moyens d'enregistrement des données issues des flux de données et des valeurs de paramètre, sur au moins un support d'information non volatile,
caractérisé en ce qu'il comporte :
- une étape d'enregistrement, pour stocker dans des fichiers séparés des données des différents flux de données et
- une étape d'association, dans chaque fichier, des données enregistrées avec des dites valeurs de paramètres d'enregistrement datées, chaque donnée de flux de données étant enregistrée en association avec le temps universel de son acquisition.

D'autres avantages, buts et caractéristiques de la présente invention ressortiront de la description qui va suivre, faite, dans un but explicatif et nullement limitatif en regard des dessins annexés, dans lesquels :
- la figure 1 représente, sous forme d'un schéma fonctionnel, un système de l'art antérieur,
- la figure 2 représente, sous forme d'un schéma logique, un mode de réalisation particulier du dispositif objet de la présente invention,
- la figure 3 représente, schématiquement, une organisation de fichiers enregistrés, dans un mode de réalisation préférentiel du procédé et du dispositif objets de la présente invention,
- les figures 4, 5 et 6 représentent, schématiquement, des structures de fichiers enregistrés selon trois modes d'enregistrement différents,
- la figure 7 représente, schématiquement, une structure de fichier mise en oeuvre dans un mode de réalisation particulier du procédé et du dispositif objets de la présente invention,
- la figure 8 représente, schématiquement, un « framework » mis en oeuvre dans un mode de réalisation particulier du procédé et du dispositif objets de la présente invention,
- les figures 9 à 14 représentent, schématiquement, des structures de fichier mises en oeuvre dans des modes de réalisation particuliers du procédé et du dispositif objets de la présente invention et
- les figures 15 et 16 représentent, sous forme de schémas logiques, des variantes de modes de réalisation particuliers du dispositif objet de la présente invention.

Dans toute la description, le terme de « disque » recouvre aussi bien les disques durs que les disques compacts.

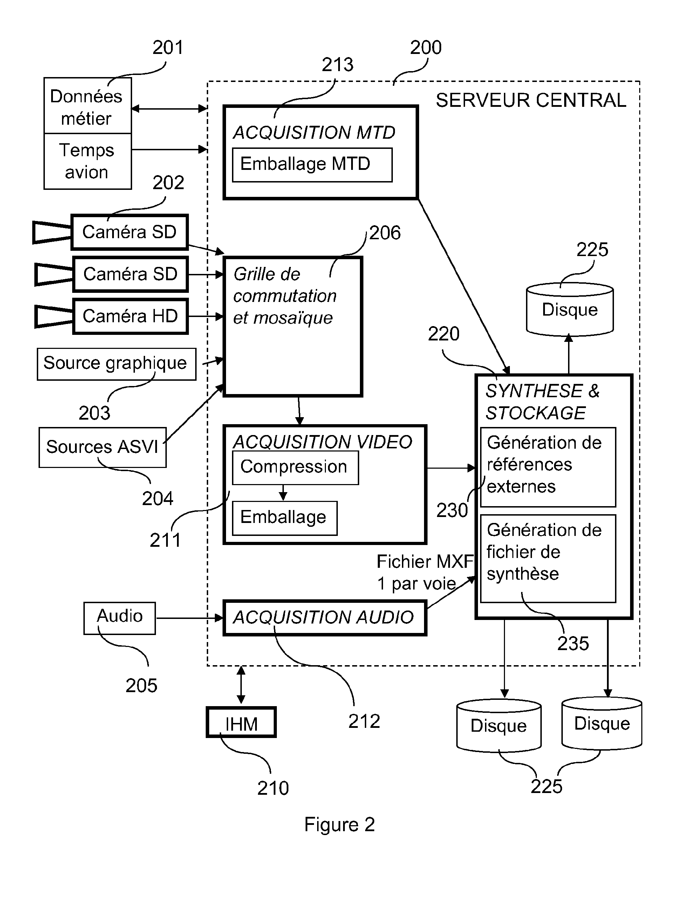

Comme illustré en figure 2, d'un point de vue logique, l'architecture d'un mode de réalisation particulier du dispositif objet de la présente invention, basé sur un serveur central 200, se divise en quatre niveaux. A gauche de la figure 2 sont représentées les sources interfaces donnant la possibilité d'acquérir des données de tout type de source. En figure 2, il s'agit d'entrées de données métier et temps avion 201, de caméras 202, d'une source graphique 203, d'une source ASVI 204 et d'une source audio 205.

On trouve ensuite, en figure 2, des systèmes permettant de router les sources vers des serveurs d'acquisition, au travers d'une grille de commutation 206 comportant, éventuellement, un système de génération de mosaïque servant à rassembler plusieurs sources SD dans une image HD, pour former une mosaïque d'images permettant d'économiser le nombre de voies enregistrées. Au centre de la figure 2 se trouvent les systèmes d'acquisition des flux audio/vidéo et des paramètres avion. Ils se chargent de récupérer les signaux envoyés par les différentes sources et de les mettre en forme sous forme de fichiers au format MXF (acronyme de « Material exchange Format » pour format d'échange de matériel). Ces différents systèmes d'acquisition peuvent fonctionner indépendamment les uns des autres (il n'est pas nécessaire de les synchroniser). En figure 2, cette partie comporte, outre une interface homme machine 210, un module d'acquisition vidéo 211, un module d'acquisition audio 212 et un module d'acquisition de métadonnées (données métier et temps avion) 213, aussi appelées « MTD » dans les figures.

On trouve enfin, en figure 2, le système de synthèse, stockage et lecture 220, qui se charge de récupérer les différents fichiers au format MXF, de les stocker sur des disques 225 et de les relire. Les différents fichiers peuvent être écrits indépendamment les uns des autres (il n'est pas nécessaire de les synchroniser). Un fichier de synthèse est généré et enregistré, au fur et à mesure, pour permettre la relecture synchrone des fichiers. A cet effet, le système de stockage 220 comporte un module de génération 230 de références externes incorporées au fichier de synthèse, par un module 235 de génération du fichier de synthèse.

Préférentiellement, selon la présente invention, on met en oeuvre un format de fichier normalisé MXF, en choisissant les fonctionnalités offertes par ce format qui sont adaptées aux besoins des IEV. Le format MXF est un format normalisé et indépendant (donc pérenne et interopérable), ouvert et évolutif (donc capable de gérer de nombreux formats vidéo et codecs différents), et de plus en plus adopté. Il peut être utilisé comme format d'échange sur toute la chaîne de production, de l'acquisition à la diffusion en passant par la post-production, l'indexation et l'archivage.

Le format MXF est évolutif. De nouvelles normes et recommandations sont écrites pour répondre à de nouvelles problématiques. Ainsi, la norme « 422M » a été récemment ajoutée pour décrire le conteneur « Jpeg2k ». La recommandation « RP 2008 » complète la norme « 381 M » pour le « H.264 ». Des normes sont en cours d'écriture pour le « VC-1 » et le « VC-3 ».

Le format MXF offre tous les mécanismes répondant aux contraintes de l'IEV, notamment :
- la gestion du mode fichier et des différents modes streaming,
- le support des références externes,
- la synchronisation d'un nombre arbitraire de flux de types différents,
- un mécanisme générique pour l'accès aléatoire et
- une gestion des métadonnées très évoluée : gestion des métadonnées statiques et dynamiques, gestion de la portée des métadonnées, « frameworks » de métadonnées normalisées couvrant de large besoins, possibilité de définir des « frameworks » de métadonnées propriétaires.

En effet, un point important de l'invention est l'utilisation et la définition d'un « framework » de métadonnées propriétaire, adapté aux besoins IEV et aéronautiques pour des utilisations plus générales.

On rappelle ici qu'un « framework » est un ensemble de bibliothèques permettant le développement rapide d'applications. Il fournit suffisamment de briques logicielles pour pouvoir produire une application aboutie. Ces composants sont organisés pour être utilisés en interaction les uns avec les autres, en particulier selon des techniques dites « d'urbanisation ».

Des tentatives de francisation du terme ont été faites. On trouve ainsi parfois les termes « cadre d'applications », proposé par l'Office québécois de la langue française ou « cadriciel ».

Un « framework » fournit un ensemble de fonctions facilitant la création de tout ou d'une partie d'un système logiciel, ainsi qu'un guide architectural en partitionnant le domaine visé en modules. Un « framework » est habituellement implémenté à l'aide d'un langage à objets, bien que cela ne soit pas strictement nécessaire : un « framework » objet fournit ainsi un guide architectural en partitionnant le domaine visé en classes et en définissant les responsabilités de chacune ainsi que les collaborations entre classes. Un sous-ensemble de ces classes peuvent être des classes abstraites.

Si l'utilisation du terme bibliothèque logicielle est limitée à la librairie proprement dite, le terme de « framework » peut être employé par extension pour inclure également l'architecture logicielle préconisée pour cette bibliothèque (organisation en couches), voire l'environnement de développement bâti autour, même si celui-ci est capable de gérer différents « frameworks ».

On trouve différents types de « frameworks » :
- « framework » d'infrastructure système : pour développer des systèmes d'exploitation, des interfaces graphiques, des outils de communication ;
- « framework » d'intégration intergicielle : pour fédérer des applications hétérogènes. Pour mettre à dispositions différentes technologies sous la forme d'une interface unique ;
- « frameworks » d'entreprise : pour développer des applications spécifiques au secteur d'activité de l'entreprise et
- « frameworks » orientés système de gestion de contenu.

Les principaux avantages de ces « frameworks » sont la réutilisation de leur code, la standardisation du cycle de vie du logiciel (Spécification, développement, maintenance, évolution), ils permettent de formaliser une architecture adaptée au besoin de l'entreprise. Ils tirent partie de l'expérience des développements antérieurs. Ces « frameworks » sont, en quelque sorte, des progiciels extrêmement souples et évolutifs.

Un autre aspect important est la diversité des sources envisagées :
- sources SD : résolutions PAL et NTSC,
- sources HD : résolutions 1920x1080, 50 images par seconde, et autre,
- sources ASVI (acronyme de « Avionic serial video interface » pour interface vidéo série avionique) ou « Arinc818 » : résolutions 1024x768, 60p, c'est-à-dire 60 images par seconde en mode progressif,
- sources VGA, SVGA (acronyme de « super video graphies array » pour super matrice graphique vidéo) et XGA (acronyme de « extended graphics array » pour matrice graphique étendue) : résolutions 640x480 à 1280x1024 60p,
- sources audio, analogiques ou numériques,
- source de données paramètres avion : environ 50 paramètres, fréquence par exemple cinq acquisitions par seconde avec la possibilité d'acquérir beaucoup plus de données et de tout type et
- d'autres types de sources.

On note que les différentes sources ne sont pas synchrones.

Optionnellement, la grille de commutation permet de regrouper les branchements au même endroit et de sélectionner les caméras que l'on souhaite enregistrer (il y a en général plus de caméras que de voies d'enregistrement disponibles). On note qu'une seule grille SD/HD-SDI est nécessaire. Elle gère des sources asynchrones et est pilotée par l'IHM de commande, qui est, par exemple, un menu affiché sur l'écran de visualisation vidéo.

Les générateurs de mosaïque permettent de regrouper à l'aide d'une mosaïque plusieurs caméras sur une même voie d'enregistrement. On peut, par exemple, regrouper plusieurs caméras SD sur une unique voie HD sans perte notable de qualité.

L'acquisition des flux audio/vidéo regroupe plusieurs étapes :
- l'acquisition des flux proprement dite,
- la compression de ces flux,
- la datation de ces flux et
- l'emballage des flux compressés et datés dans des fichiers au format MXF.

La compression se fait selon un des codecs (compression des termes « codeur » et « décodeur ») retenus. Une première compression en haute qualité est effectuée en temps réel par le serveur d'acquisition, afin de limiter le débit des flux transférés vers le module de stockage. Une seconde compression, en qualité proxy, est, si possible, effectuée en simultané, afin d'éviter une étape de génération de proxy au sol. Plusieurs codecs peuvent être utilisés au sein d'un même serveur, en fonction des sources et de la qualité recherchée.

Les différents flux sont précisément codés temporellement, ou « timecodés », c'est-à-dire datés en fonction du moment où ils ont été acquis, avec une précision de l'ordre de la durée d'une image. Plusieurs méthodes sont envisagées :
- un convertisseur GMT/Timecode AES est placé en amont des moyens d'enregistrement. Ces moyens d'enregistrement, sont munis d'une entrée timecode AES, qui permet de dater les images acquises en fonction du timecode AES. Cette méthode peut être directement adaptée, car la datation à partir d'un timecode AES est disponible sur tous les serveurs d'acquisition vidéo du commerce. Elle repose exclusivement sur le matériel, et est donc plus précise. Elle nécessite, en revanche, le développement d'un convertisseur GMT/Timecode AES matériel, et n'est pas robuste aux pannes (la datation devient impossible en cas de panne du convertisseur ou de problème de transmission du signal AES).
- une méthode basée sur l'horloge interne des serveurs : l'horloge interne des serveurs d'acquisition peut être synchronisée sur l'horloge de l'avion en utilisant les mêmes mécanismes que sur les racks d'acquisition des paramètres avion ou en utilisant le serveur NTP (acronyme de « Network Time Protocol» pour protocole de datation sur réseau) du calculateur de bord. Par exemple, une mise à l'heure de l'horloge interne peut être faite par un serveur NTP externe, ou un convertisseur GMT/Timecode AES à partir d'une entrée timecode AES.

Grâce à ces données temporelles, les moyens d'enregistrement sont adaptés à fournir des données enregistrées, sous forme de rejeu d'un ou plusieurs flux de données synchronisés.

Les cartes d'acquisition du commerce utilisent leur propre horloge pour dater les images acquises. Un module du logiciel d'acquisition doit donc être développé pour permettre de faire la correspondance entre l'horloge des cartes d'acquisition et l'horloge interne des serveurs et dater ainsi la vidéo en fonction de l'horloge interne des serveurs. Cette méthode nécessite donc une petite adaptation du logiciel d'acquisition, mais ne nécessite en revanche pas de matériel spécifique. Elle est plus robuste aux pannes (l'horloge interne des serveurs et continue à être utilisable et suffisamment précise pendant plusieurs jours en cas de perte de la synchronisation).

La méthode de datation prend en compte les latences de transmission induites par le système de routage entre les appareils d'acquisition (caméra, micro, autre...) et les serveurs d'acquisition. Cette latence est en effet nulle en cas de transmission directe, mais peut atteindre quelques images de décalages lorsqu'elle se fait par l'intermédiaire d'un générateur de mosaïque. Cette latente étant connue, elle est compensée par le dispositif, selon des techniques connues.

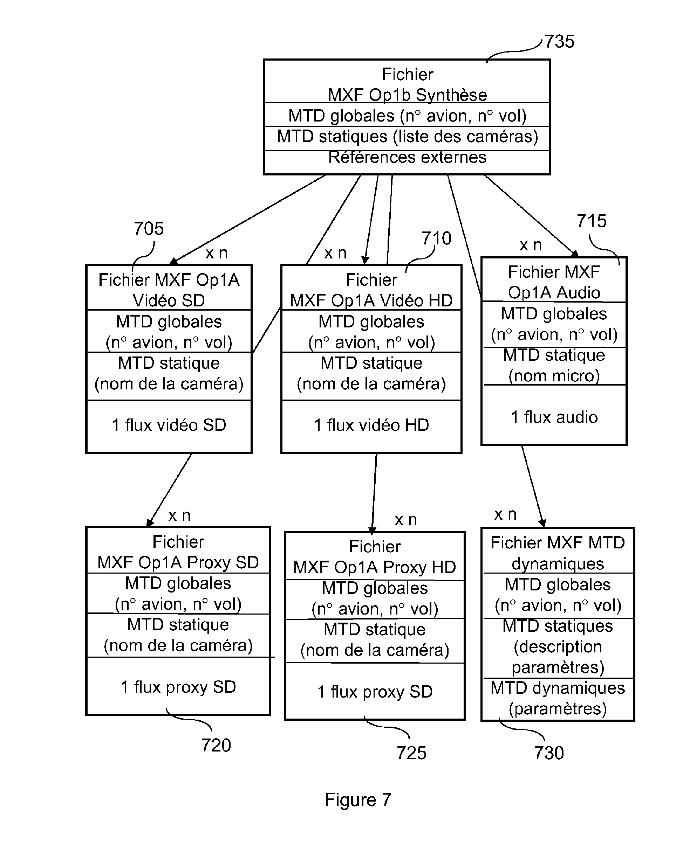

Chaque flux est, au fur et à mesure, emballé dans un fichier au format MXF atomique. Ce fichier contient les métadonnées statiques décrivant l'avion, l'essai et la source de données, une piste audio ou vidéo contenant le flux acquis, et une piste de code temporel, ou « timecode », dynamique contenant les dates de chaque image. Ce fichier suit la structure retenue pour les fichiers bord, détaillée en regard de la figure 7.

Une fonction de pré-enregistrement peut, en variante, être intégrée aux serveurs : lorsque l'enregistrement n'est pas activé, les flux compressés et datés sont stockés dans un espace temporaire, de préférence en mémoire vive, et conservés pendant un certain temps. Lorsque l'enregistrement est démarré, ils sont intégrés au fichier au format MXF généré.

L'acquisition des paramètres avion regroupe plusieurs étapes :
- la mise en place de la connexion au système émetteur de données,
- l'acquisition des paramètres (valeurs et dates d'acquisition) fournis par le système émetteur de données,
- le tri de ces paramètres en fonction de leur date d'acquisition et
- l'emballage dans un fichier au format MXF.

Les deux premières étapes correspondent à l'implémentation d'un client au système émetteur de données standard. Elles permettent de s'abonner à une liste de paramètres, récupérer des informations générales sur ces paramètres (noms, unités), puis de récupérer, à intervalles de temps réguliers, toutes les valeurs industrielles, c'est-à-dire directement exploitables, mesurées pour ces paramètres avec leurs dates d'acquisition.

La troisième étape est spécifique à l'IEV vidéo. Elle permet de réorganiser temporellement les paramètres de manière à pouvoir les stocker et les exploiter de la même façon qu'un flux audio/vidéo. Un flux audio/vidéo est en effet divisé en segments de durée fixe, cette durée correspondant en général à la période ou à la fréquence des trames, ou « framerate », des images, par exemple 40 ms pour une vidéo à 25 images/seconde. Le logiciel d'acquisition des paramètres divise le temps en segments de durée fixe (correspondant à la fréquence souhaitée pour les paramètres), et, pour chaque segment et chaque paramètre, conserver la valeur la plus récente du paramètre acquise pendant ce segment temporel (ou la dernière valeur disponible si aucune n'a été acquise pendant ce segment temporel).

Les segments temporels ainsi générés sont, au fur et à mesure, emballés dans un fichier au format MXF atomique. Ce fichier contient des métadonnées statiques décrivant l'avion et l'essai, ainsi que les différents paramètres acquis. Il contient aussi une piste de métadonnées dynamiques, divisée en segments de durée fixe, dans lesquelles sont enregistrées les valeurs et les dates d'acquisition des paramètres retenues pour chaque segment temporel. Ce fichier suit la structure retenue pour les fichiers de bord, structure détaillée en regard de la figure 7.

Comme pour les flux audio/vidéo, une fonction de pré-enregistrement est intégrée au logiciel d'acquisition.

En ce qui concerne le stockage et la gestion des séquences, les fichiers au format MXF issus des différentes acquisitions sont enregistrés sur au moins un disque de stockage. Chaque fichier est enregistré sur un seul disque, au fur et à mesure de sa génération.

Préférentiellement, chaque disque enregistre une copie de tous les fichiers. Cependant, si le débit cumulé des différents fichiers est trop important par rapport au débit supporté par un seul disque, on répartit les débits sur plusieurs disques, en enregistrant certains fichiers sur un disque, certains sur un autre disque, en mettant en oeuvre autant de disques que nécessaire.

Le tableau suivant donne des exemples de débits et volumes de fichiers nécessaires :

| | Débit (Mb/s) | Débit (Mo/s) | Place 4h (Go) | Place 6h (Go) |
|---|---|---|---|---|
| 1 caméra SD | 10 | 1,3 | 18 | 27 |
| 1 caméra HD | 40 | 5 | 72 | 108 |
| 1 proxy SD | 1 | 0,1 | 1,8 | 2,7 |
| Configuration 6 SD | 70 | 8,8 | 126 | 189 |
| Configuration 4 SD+2 HD | 130 | 16 | 234 | 351 |

Un logiciel scrute les fichiers issus des différentes acquisitions et génère un fichier au format MXF de synthèse permettant de référencer et relire, de façon synchrone, ces fichiers. Ce fichier contient des références externes pointant vers chacun des fichiers acquis par ailleurs. Il contient les métadonnées statiques décrivant l'avion et l'essai, ainsi qu'une copie des métadonnées statiques spécifiques à chaque fichier (identifiant des caméras, description des paramètres). Ce fichier étant petit mais critique, il est réécrit intégralement à intervalles de temps réguliers, préférentiellement, à deux emplacements différents sur deux disques différents. Ainsi, un fichier correct est toujours disponible en cas de détérioration du deuxième système de stockage.

Pour faciliter le transfert au sol, préférentiellement, on enregistre les fichiers acquis simultanément dans un même répertoire (ou dans des répertoires portant le même nom lorsque les fichiers sont répartis sur plusieurs disques).

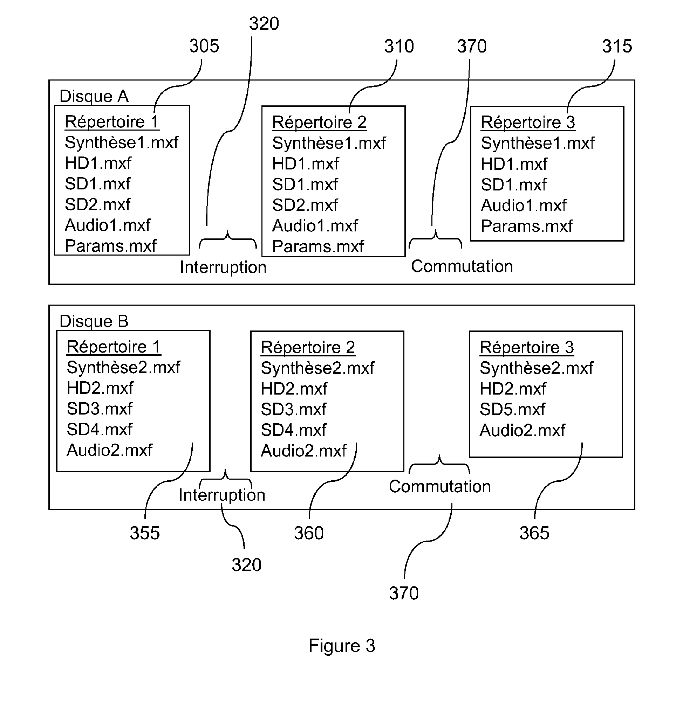

Durant un essai en vol, l'enregistrement peut être arrêté, redémarré ou reconfiguré. Préférentiellement, pour faciliter l'exploitation, comme illustré en figure 3, on subdivise les enregistrements en séquences continues 305, 310, 315, 355, 360 et 365, c'est-à-dire sans interruptions, et homogènes, c'est-à-dire sans changement de configuration. On crée donc un nouveau répertoire avec de nouveaux fichiers pour chaque nouvelle séquence, à chaque fois que l'enregistrement est redémarré après une interruption 320 ou reconfiguré, quelle qu'en soit la raison (commutation de caméra, changement de disque, redémarrage suite à un crash), ici, à la suite d'une commutation 370.

En ce qui concerne l'interface homme-machine (« IHM »), l'utilisateur peut, grâce à elle, modifier les sources qu'il souhaite enregistrer. Deux solutions sont envisagées pour effectuer une commutation de source sans être gêné par le fait qu'elles ne sont pas synchrones :
- dans une première variante, on synchronise toutes les sources SDI pour éviter la perte d'image : cette solution implique l'installation d'un matériel de synchronisation ou d'une grille de commutation équipée de fonctions de « reclocking »,
- dans une deuxième variante, on arrête l'enregistrement avant la commutation et on le redémarre après la commutation. Ceci implique la perte de quelques images sur la voie commutée, mais ne nécessite pas d'adaptation du matériel. L'arrêt et le redémarrage de l'enregistrement sont effectués automatiquement par le serveur vidéo, de manière transparente pour l'utilisateur.

Afin de limiter les impacts des « crashs » et des pannes, on prévoit :
- la génération de fichiers au format MXF en mode « streaming », c'est-à-dire en continu, qui permet de limiter les pertes de données en cas de crash,
- des fonctions de reprise sur erreurs : les acquisitions sont relancées automatiquement en cas d'erreur,
- des fonctions de diagnostic qui vérifient l'état de l'IEV vidéo avant un essai,
- des fonctions de détection de panne pendant un essai (perte de signal, perte ou gel d'une image, problèmes avec un système d'acquisition, de datation ou de stockage), qui lèvent une alarme et stoppent l'acquisition des voies concernées, le cas échéant.

En ce qui concerne le format de fichier choisi, Les fichiers utilisés dans le cadre de l'IEV vidéo permettent de stocker plusieurs types de flux vidéo et audio : des vidéos SD (formats PAL et NTSC), des vidéos HD (formats de type 720p et 1080i), des vidéos issus d'ordinateurs (formats de type VGA), et des vidéos issus du cockpit (formats ASVI), de l'audio, d'autres données provenant de besoins futurs.

Ces flux sont compressés afin de limiter les débits nécessaires pour leur transfert et les volumes nécessaires pour leur stockage. Plusieurs codecs différents sont utilisés, pour obtenir un bon compromis entre la qualité des images et la taille des fichiers. Ce compromis peut varier en fonction du mode d'exploitation des fichiers, et il est parfois nécessaire de stocker une même vidéo avec plusieurs taux de compressions différents : faiblement compressé (vidéo haute qualité pour exploitation sur banc) et/ou fortement compressé (proxy pour exploitation sur poste de travail individuel).

Les fichiers permettent de documenter ces flux audio/vidéo de métadonnées standard (droits, titre, participants, ...). Les fichiers permettent aussi de stocker des métadonnées métier qui s'appliquent à tous les flux (description de l'avion et du vol, ...) ou seulement à certains flux (description caméra, ...). Ces métadonnées sont facilement modifiées et indexées dans une base de données.

Enfin, ces fichiers sont aussi utilisés pour enregistrer des flux de paramètres (paramètres avions) qui sont stockés sous forme de métadonnées dynamiques.

Les différents flux audio/vidéo issus de différentes sources sont acquis par plusieurs processus différents (voire plusieurs machines différentes). Il est difficile de synchroniser ces processus et regrouper les différents flux acquis dans un fichier unique. On préfère donc acquérir les différents flux de manière asynchrone et dans des fichiers séparés (au moins un fichier par processus). On horodate alors précisément chaque flux, pour permettre de les synchroniser ultérieurement.

Comme indiqué plus haut, les débits des disques utilisés dans l'architecture bord étant parfois insuffisants pour supporter le débit cumulé des différents flux, le cas échéant on répartit les débits sur plusieurs disques.

Les processus d'acquisition peuvent être arrêtés de manière brutale, pour de multiples raisons (coupure d'alimentation, disque plein, problème matériel ou logiciel, ...). Dans ce cas, les fichiers peuvent être exploités, même s'ils n'ont pas été fermés correctement. Les fichiers sont donc acquis en mode streaming, c'est-à-dire en écrivant régulièrement les informations vitales permettant de relire le fichier.

Enfin, il est possible de changer le nombre et les sources des flux (changement de source vidéo). Ces changements sont « tracés » au travers des métadonnées dans les fichiers. Les fichiers sont vérifiés et peuvent être remis en forme lors du transfert au sol. On dispose, à cet effet, de fonctions de vérification et de manipulation des fichiers.

Un avantage important de la mise en oeuvre de la présente invention, qui n'existait pas dans l'art antérieur, est que les flux peuvent être exploités individuellement par l'intermédiaire du réseau. Préférentiellement, on a un seul flux par fichier, de manière à ne pas surcharger le réseau.

Les flux peuvent aussi être exploités collectivement (sur banc d'exploitation), comme dans l'art antérieur. Le format de fichier choisi permet d'associer, référencer et synchroniser, plusieurs flux datés, contenus dans plusieurs fichiers, de manière à pouvoir effectuer une relecture parfaitement synchrone de ces différents flux.

Quel que soit le mode d'exploitation, l'utilisateur souhaite pouvoir se déplacer rapidement dans les vidéos, et accéder rapidement à un instant précis de l'enregistrement. Le fichier retenu permet un accès aléatoire aux images.

De plus, les vidéos issues des essais constituent une donnée sensible. Le format de fichier retenu permet d'assurer la confidentialité des données. Le format de fichier peut, par exemple :
- être exploité en mode « streaming » : le fichier est alors diffusé jusqu'à l'utilisateur par le réseau, sans que l'utilisateur puisse le copier et
- être crypté pour ne pas être lisible.

L'utilisateur peut aussi vouloir extraire une partie d'une vidéo, y incruster des données et l'exporter pour une utilisation externe, après autorisation. Le type de fichier retenu supporte les mécanismes de « partial restore », extraction de certains flux sur une plage de temps donnée, incrustation de texte, décompression/recompression.

En ce qui concerne les codecs, l'architecture décrite ci-dessus permet l'utilisation de différents codecs simultanément, par exemple, « Mpeg4 AVC (H.264) », « VC-1 », « Jpeg2k », « Mpeg2 », codecs « Dirac » et « H.265 ».

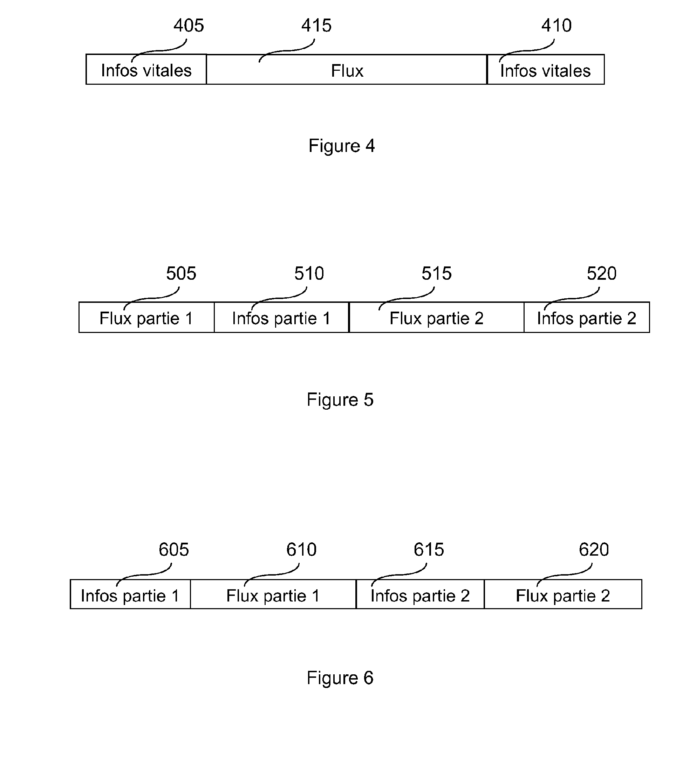

En ce qui concerne le mode d'enregistrement, le format de fichier MXF permet de stocker les flux dans plusieurs modes différents :
- en mode « fichier », dans lequel le fichier est divisé en deux ou trois blocs, comme illustré en figure 4. L'en-tête 405 (en anglais « header ») et/ou le pied 410 (en anglais « footer ») de fichier contiennent les informations permettant de relire le fichier. Le corps 415 du fichier contient les flux. Ce mode est utilisé lorsque les fichiers sont stockés sur un support permettant l'accès aléatoire (disque ou CD) ;
- en mode « streaming acquisition » (en français acquisition continue), dans lequel le fichier est divisé en plusieurs partitions, comme illustré en figure 5. Chaque partition contient les flux acquis 505 et 515, suivis d'un bloc d'informations 510 et 520 permettant de relire ces flux. Ce mode est utilisé lorsque les fichiers sont acquis sur un support linéaire (bande), ou lorsque l'acquisition risque d'être interrompue brutalement. Seuls les flux situés après le dernier bloc d'informations lisible ne peuvent être facilement décodés ;
- en mode « streaming lecture », dans lequel le fichier est divisé en plusieurs partitions, comme illustré en figure 6. Chaque partition contient les flux acquis 610 et 620 précédés d'un bloc d'informations 605 et 615 permettant de lire ces flux. Ce mode est utilisé lorsque les fichiers doivent être relus à partir d'un support linéaire (bande) ou lorsqu'ils doivent être diffusés sur un réseau, par câble ou par les ondes. Seuls les flux qui précédent le premier bloc d'informations lisible ne peuvent être décodés.

Dans des utilisations de la présente invention, les modes « streaming acquisition » et fichier sont mis en oeuvre, respectivement à bord et au sol.

En ce qui concerne les mécanismes de synchronisation : le format de fichiers MXF fournit des mécanismes de synchronisation permettant de synchroniser un nombre arbitraire de flux, quels que soient leurs types et leurs répartitions dans le(s) fichier(s).

En ce qui concerne les références externes, le format MXF permet de stocker les différents flux pouvant constituer une séquence audio/vidéo dans des fichiers différents, appelés fichiers « atomiques », et de construire un fichier, appelé « fichier de synthèse », qui référence les fichiers contenant les flux devant être relus. Chaque flux est stocké dans un fichier séparé. Un fichier de synthèse est construit pour chaque diffusion. Il indique quels flux doivent être diffusés. Ce mécanisme permet d'enregistrer et d'exploiter les flux dans des fichiers différents.

En ce qui concerne la gestion des métadonnées, le format MXF permet de gérer des métadonnées standards (titre, détenteur des droits) et des métadonnées plus spécifiques (description de l'avion et de l'essai) dites « propriétaires ». De plus, les fichiers utilisés dans l'application de la présente invention aux essais en vol, contiennent des métadonnées ne s'appliquant qu'à un seul flux (description d'une source). Enfin, le format MXF permet de définir des métadonnées dynamiques, pour stocker les paramètres avions.

Parmi les avantages du format MXF relatifs à sa structure physique, on peut citer les suivants :
- il permet la mise en oeuvre d'une table d'index qui indique où se trouvent les différentes images enregistrées dans les différents flux. Elle permet donc d'accéder aléatoirement à une image pour un flux et un instant donné,
- il permet la mise en oeuvre d'un conteneur d'essences qui contient les flux sous leur forme brute : flux audio et/ou vidéo, éléments dynamiques (timecodes discontinus et/ou métadonnées dynamiques). Ces flux sont en général découpés en morceaux qui correspondent à une durée fixe, la durée d'une image ou d'un GOP (acronyme de « group of pictures » pour groupe d'images), et on parle alors de « frame-wrapping ». Les flux peuvent aussi être emballés d'un bloc (qui correspond à la durée globale de la séquence), et on parle alors de « clip-wrapping ».

En ce qui concerne les avantages du format MXF relatifs à sa structure logique, on peut citer celui de la structure logique des fichiers au format MXF, qui est indépendante de leur structure physique. Il est donc possible d'organiser et synchroniser les différents flux et les métadonnées entre eux quels que soient leurs types et leurs emplacements.

En ce qui concerne la gestion des métadonnées, les fichiers au format MXF utilisent un seul modèle de métadonnées, qui permet de définir à la fois des métadonnées structurelles et des métadonnées descriptives. Les métadonnées structurelles regroupent les informations vitales permettant de décrire la structure logique du fichier, ainsi que certaines informations permettant de garder trace de sa création et de ses modifications. Elles sont obligatoires et normalisées. Les métadonnées descriptives permettent d'agrémenter le fichier avec des informations destinées à l'utilisateur. Elles sont facultatives. Elles sont organisées sous forme de « framework ».

Trois « frameworks » de métadonnées ont déjà été normalisés sous le nom « DMS-1 » pour répondre aux besoins de l'audiovisuel. On peut aussi définir et utiliser des « frameworks » de métadonnées propriétaires (on parle alors de « Dark Metadata »). Certains logiciels mettant en oeuvre le format MXF permettent de visualiser le contenu des « frameworks » DMS-1 et permettent de les importer et les exporter sous forme de fichiers au format XML (acronyme de « extensible markup language » pour langage à balisage étendu). Ils ignorent en revanche les « frameworks » propriétaires, sans les supprimer pour autant.

En ce qui concerne les mécanismes de datation et de synchronisation, le format MXF permet la datation et la synchronisation des différents flux. Chaque piste (flux audio/vidéo ou métadonnées dynamiques) possède sa propre base de temps (« framerate ») et origine. Les lecteurs de fichiers au format MXF permettent un accès aléatoire aux données à partir d'un temps absolu par le mécanisme suivant : pour chaque piste, le temps absolu est converti en timecode en fonction de la base de temps de la piste. Les tables d'index permettent alors de retrouver l'image associée à ce timecode, même dans une structure de GOP. Ce mécanisme permet d'assurer une lecture synchrone des pistes, même lorsqu'elles n'utilisent pas la même base de temps.

Les fichiers au format MXF permettent de gérer certaines fonctionnalités plus spécifiques, notamment :
- « Partial restore » : il s'agit des mécanismes permettant, à partir d'un fichier au format MXF, d'extraire des flux et des métadonnées sur une plage de temps donnée, et de les enregistrer sous forme de fichiers bruts, ou dans un autre fichier au format MXF et
- « Cryptage AES » : les essences dans les fichiers au format MXF peuvent être cryptées en utilisant l'algorithme AES.

Pour éviter les problèmes d'interopérabilité, préférentiellement, on produit des fichiers aillant une structure simple et répandue, par exemple de type « Op1 a », et qui respectent parfaitement la norme (des outils comme le logiciel mettant en oeuvre le format MXF nommé « analyser » ou « analyzer » de l'IRT (acronyme de « Institut für Rundfunktechnik », marques déposées) permettent de détecter les incompatibilités des fichiers avec la norme).

Préférentiellement, pour mettre en oeuvre la présente invention, on enregistre les flux dans plusieurs fichiers différents, ce qui présente les avantages suivants :
- à bord, les fichiers sont générés par plusieurs processus différents et peuvent être enregistrés sur plusieurs disques différents et
- au sol, le stockage des différents flux dans des fichiers séparés permet de limiter la taille des fichiers, et la quantité de données à traiter en fonction des requêtes, seuls les fichiers contenant les flux demandés doivent par exemple être remis nearline. On rappelle ici que « Nearline » qualifie un système d'accès rapide qui rend rapidement disponibles, comme sur un support de données à accès aléatoire, des données archivées sur un support à accès séquentiel.

Dans un mode de réalisation, on met en oeuvre une atomisation des flux, et l'utilisation de la structure de fichiers illustrée en figure 7.

Comme on l'observe en regard de la figure 7, on utilise deux types de fichiers :
- les fichiers atomiques 705 à 730, qui contiennent chacun un seul flux (vidéo haute qualité, vidéo proxy, audio ou métadonnées dynamiques) et les métadonnées statiques renseignant l'essai (identifiant avion et vol) et le flux (identifiant de caméra, de micro ou description des paramètres). Les fichiers atomiques 705 à 730 peuvent être exploités individuellement et
- le fichier de synthèse 735 qui référence les différents fichiers 705 à 730 contenant les flux. Le fichier de synthèse 735 permet, à lui seul, d'obtenir toutes les informations sur l'essai en vol et les différents flux : le fichier de synthèse 735 contient les métadonnées statiques renseignant l'essai (identifiant avion et vol) et les métadonnées statiques renseignant chacune des sources (identifiant caméra, micro ou description des paramètres...). Le fichier de synthèse 735 permet aussi d'exploiter ces différents flux de manière synchrone.

En ce qui concerne le « frameworks de métadonnées », les différents fichiers au format MXF contiennent des métadonnées descriptives statiques (droits, identifiant de l'avion, ...) et, parfois, dynamiques (paramètres avions) répondant au besoin avion, c'est-à-dire au besoin d'associer certains paramètres mesurés tel que la vitesse ou la pression, selon le type d'essai réalisé sur avion.

On observe que l'on peut utiliser un « framework » normalisé « DMS-1 » pour les métadonnées statiques standards qui ne sont pas confidentielles. Ces métadonnées peuvent, en effet, être consultées dans certains logiciels mettant en oeuvre le format MXF. On utilise, par exemple, un « production framework » pour indiquer le détenteur des droits et ses coordonnées.

On peut aussi utiliser un « framework » DMS-1 de manière détournée pour stocker les métadonnées métier statiques (identifiant de l'avion, du vol, de caméra et micros, description des paramètres). On peut, par exemple, utiliser un « scene framework » pour identifier l'avion et les caméras, et permettre ainsi leur visualisation dans la plupart des logiciels mettant en oeuvre le format MXF.

Dans des modes de réalisation préférentiels, on utilise un « framework » propriétaire pour ces métadonnées métier statiques, car il permet de leur donner exactement le nom et le type voulu, et de faciliter ainsi leur visualisation, leur édition et leur indexation.

De plus, ce « framework » propriétaire est adapté au stockage des données paramètres avions, car il permet de limiter fortement le nombre d'octets nécessaires pour stocker ces paramètres (environ 16 octets par paramètres au lieu de plusieurs centaines avec un « framework » DMS-1 détourné).

L'utilisation d'un « framework » propriétaire permet, en outre, d'assurer une certaine confidentialité. Les métadonnées qu'il contient sont en effet ignorées par les logiciels mettant en oeuvre le format MXF du marché. Seul un logiciel modifié ou configuré à l'aide d'un schéma décrivant le « framework » propriétaire peut les interpréter.

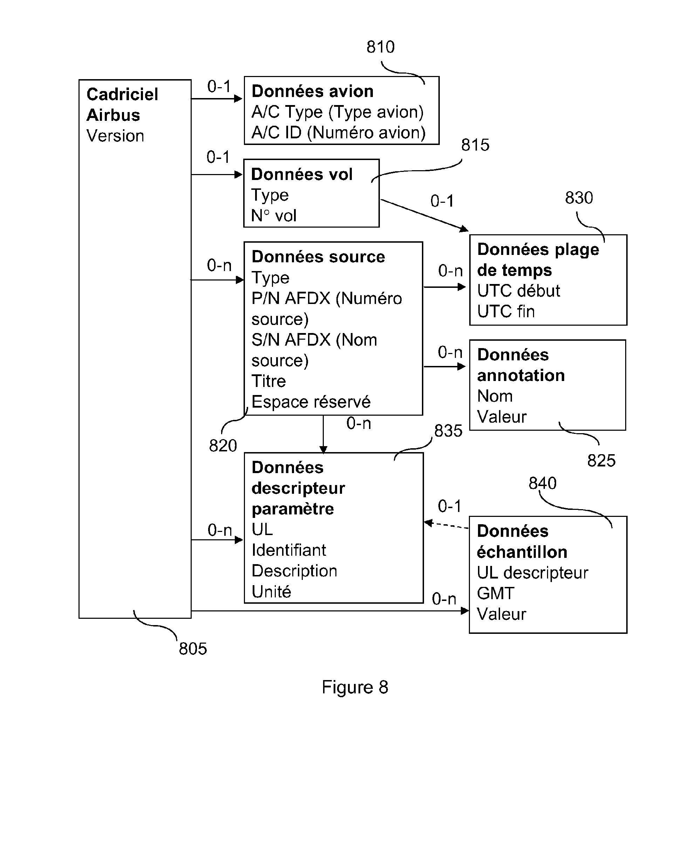

Dans des modes de réalisation, on met en oeuvre un « framework » dont la structure est illustrée en figure 8. Un tel « framework » 805 permet de stocker des métadonnées statiques :
- type d'avion et identifiant de l'avion, bloc 810 ;
- type de vol (essai statique, essai en vol, vol commercial) et numéro de vol, bloc 815 ;
- identifiant des sources, par exemple type, P/N (acronyme de « Part Number » pour numéro de partie), qui identifie l'équipement de manière unique, S/N (acronyme de « Serial Number » pour numéro de série), qui identifie le numéro de série de l'équipement, titre et espace réservé, bloc 820 ;
- annotations supplémentaires relatives aux sources, bloc 825 et
- plage de temps en UTC (le temps universel coordonné, UTC étant un compromis entre l'anglais « CUT » pour « Coordinated universal time » et le français « TUC »), pour le vol et pour chaque enregistrement, bloc 830.

Ce « framework » permet, de plus, de stocker les paramètres avions et les paramètres propres à chaque source, par exemple pour l'EVS (acronyme de « Enhanced Vision System » pour système de vision avancé) : position calculée de l'horizon, valeurs de gain, activation du dégivrage, mode, position GPS (acronyme de « Global Positionning System » pour système de positionnement global) :
- les descriptions de chaque paramètre sont stockées de manière statique et assorties d'un UL (acronyme de « Universal Label » pour étiquette universelle), bloc 835 et
- les échantillons de paramètres sont stockés de manière dynamique, bloc 840. Ces échantillons ne contiennent que la valeur (sans unité) et le temps GMT (date d'acquisition) de chaque paramètre, afin de limiter l'espace nécessaire. Ces échantillons référencent les descripteurs de paramètres par le biais d'un UL pour permettre de retrouver le nom et l'unité du paramètre.

Ce « framework » 805 est conçu pour satisfaire des applications aéronautiques autres que les essais en vol, comme exposé plus bas.

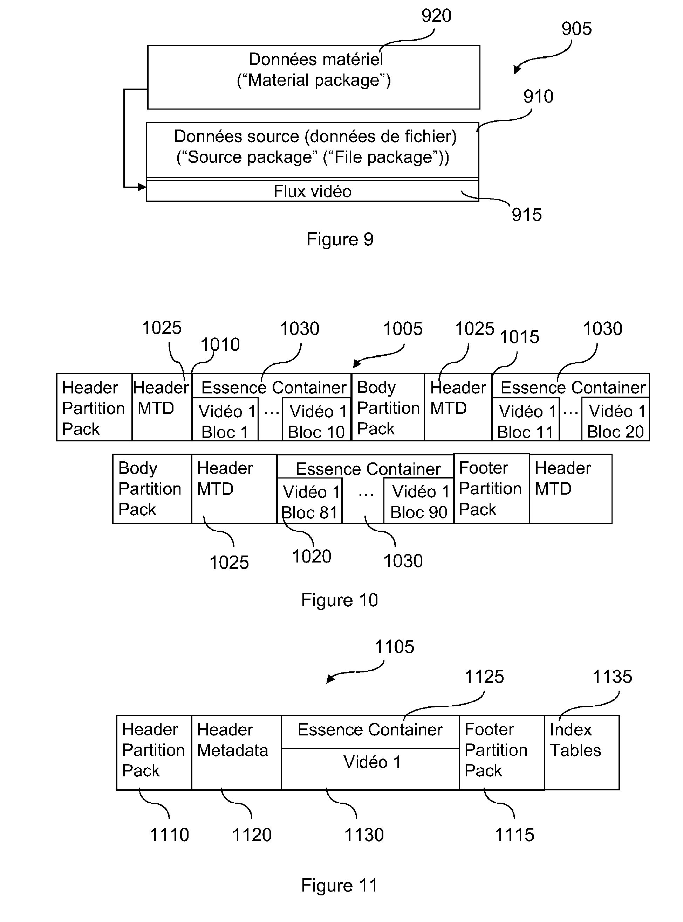

En ce qui concerne la structure des fichiers audio/vidéo, chaque flux audio ou vidéo est stocké dans un fichier séparé 905, illustré en figure 9, qui peut être utilisé isolément dans un lecteur ou un logiciel de montage mettant en oeuvre le format MXF.

Ces fichiers ne contiennent donc qu'un seul « source package » 910, qui contient le flux audio ou vidéo 915 et éventuellement une piste de timecode (non représentée) discontinus, et un seul « material package » 920, qui permet de rejouer ce flux dans son intégralité. Le material package 920 a la forme demandée à la sortie, c'est-à-dire la forme lue par un lecteur vidéo classique. Les éléments de cette structure sont mis en place et reliés aux données brutes, « source package », par un « file package » (que l'on peut traduire en français par fichier d'assemblage). Cette représentation logique est très compacte : un « file package » typique correspond à environ 1 ko alors que l'essence qu'il représente peut être de plusieurs Megaoctets, Gigaoctets ou même Teraoctets.

La structure « Op1a » est préférentielle car elle est simple et répandue, et permet d'assurer une bonne interopérabilité (les fichiers sont utilisables dans la quasi-totalité des lecteurs et logiciels de montage mettant en oeuvre le format MXF). La structure « Op0 », en cours de normalisation, peut, à terme, être intéressante car elle permettra d'optimiser les fonctions de lecture pendant l'enregistrement.

Ces fichiers peuvent avoir deux structures physiques différentes :
- à bord, comme illustré en figure 10, les fichiers 1005 sont acquis en mode « streaming acquisition », pour qu'ils puissent être utilisés même s'ils n'ont pas été fermés correctement. Ils sont divisés en plusieurs partitions 1010, 1015 et 1020, qui correspondent à une durée choisie. Ainsi, en cas de crash, seuls les flux situés dans la dernière partition 1020 ne peuvent être facilement décodés. Chaque partition est composée d'un arbre de métadonnées 1025 et d'un conteneur d'essence 1030. Chaque arbre de métadonnées 1025 contient les métadonnées structurelles (qui donnent la structure logique du fichier), et les métadonnées descriptives statiques (droits, identifiant de l'avion et du vol, identifiant de la caméra ou du micro). Chaque conteneur d'essence 1030 emballe le flux en mode « frame-wrapping », sur une durée fixe (une image ou un GOP) ; avec des données qui permettent de transmettre correctement le fichier (information sur le taille de la partition, sa position dans le flux, par exemple...). Au sol, comme illustré en figure 11, les fichiers sont convertis en mode « fichier ». Les fichiers résultants 1105 ne contiennent plus qu'une partition header 1110 et une partition footer 1115. Ces partitions contiennent un arbre de métadonnées 1120 qui rassemble les métadonnées structurelles, et les métadonnées descriptives statiques. Un seul conteneur d'essence 1125 est utilisé pour emballer le flux (éventuellement crypté) en « clip-wrapping », en un seul bloc 1130. Une table d'index 1135 est automatiquement ajoutée pour permettre un accès rapide à chaque image, selon des techniques connues en soi.

En ce qui concerne les fichiers de métadonnées dynamiques, ce fichier contenant les paramètres avion ou les autres données à associer suit les mêmes structures logiques et physiques que les fichiers contenant les flux audio/vidéo.

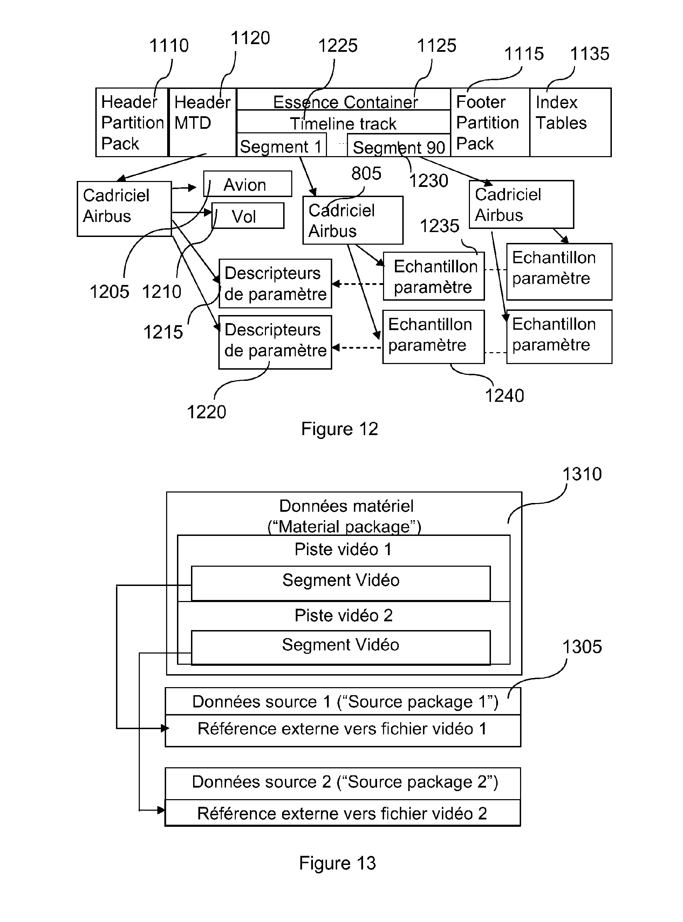

Il existe cependant quelques différences sur les métadonnées et les flux qui sont emballés, qui sont expliquées ici, en regard de la figure 12. La première différence concerne les métadonnées descriptives statiques. Le jeu (en anglais « set ») de métadonnées identifiant la source audio/vidéo est remplacé par un ensemble, ou liste, de jeux de métadonnées 1205 à 1220 décrivant des paramètres. Chaque jeu descripteur de paramètre stocke le nom, la description et l'unité d'un paramètre, ainsi qu'un UL (Universal Label), un identifiant qui est différent pour chaque paramètre.

La seconde différence porte sur l'essence. Le flux audio/vidéo est remplacé par une piste de métadonnées dynamique de type « timeline » 1225, timeline étant une méthode de datation des données, qui contient les échantillons de paramètres. Ceux-ci sont triés et répartis dans des segments de durée fixe (par exemple, 200 ms si 5 pps (acronyme de « paramètres par seconde ») 1230, en fonction de leur date d'acquisition (et non en fonction de la date de réception par le serveur), et on ne garde qu'un seul échantillon par paramètre et par segment. Chaque échantillon 1235 est stocké en association avec un jeu de métadonnées échantillon de paramètre 1240 qui stocke la valeur et la date d'acquisition de la valeur du paramètre et référence le jeu descripteur de paramètre correspondant par le biais de son UL..

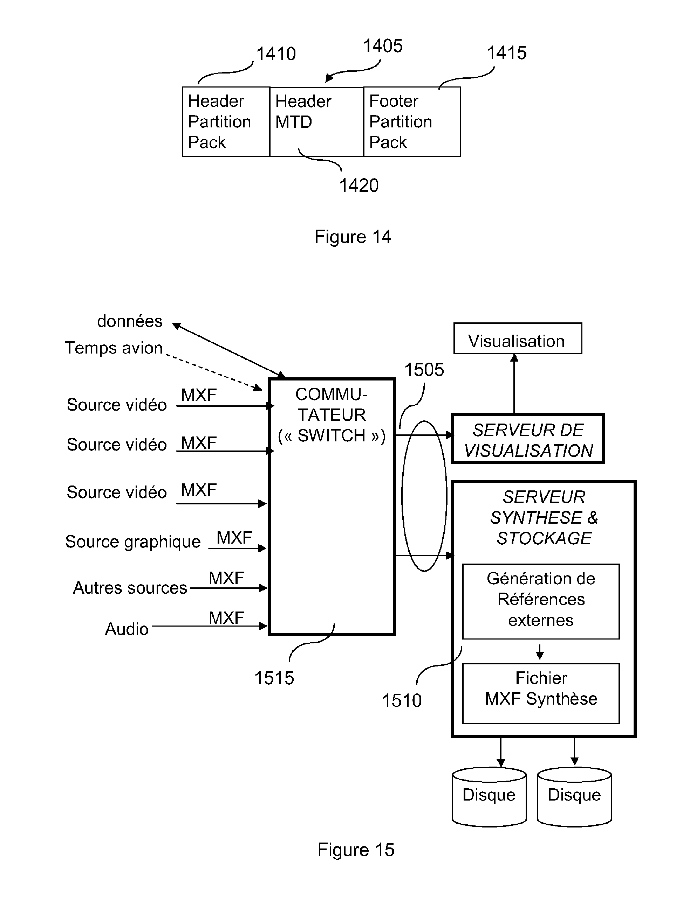

En ce qui concerne le fichier de synthèse, qui référence tous les autres fichiers pour permettre de les relire de manière synchrone, il est constitué de plusieurs « sources packages » 1305, chacun faisant référence à un fichier contenant un flux vidéo, audio ou paramètres, et d'un « material package » 1310, qui permet de rejouer tous ces flux de manière synchrone, comme illustré en figure 13. Une structure de type « Op1 b » permet de gérer cette complexité. Ce fichier est donc moins facilement interopérable. La structure physique de ce fichier est, en revanche, plus simple, comme illustré en figure 14. Ce fichier 1405 ne contient qu'un « partition header » 1410, un « header metadonnées » 1420 et un « partition footer » 1415. l'entête 1410 et le pied 1415 contiennent les métadonnées structurelles qui donnent la structure logique du fichier, et les métadonnées statiques qui reprennent les métadonnées statiques globales (identifiant d'avion et de vol), et les métadonnées statiques associées à chaque flux (identifiant de sources, liste des paramètres).

Du point de vue de l'architecture, plusieurs choix techniques sont possibles, comme, par exemple :
- le choix de la compression, logicielle ou matérielle,
- le choix de la visualisation et
- l'ajout d'un module pour une fonction de rejeu.

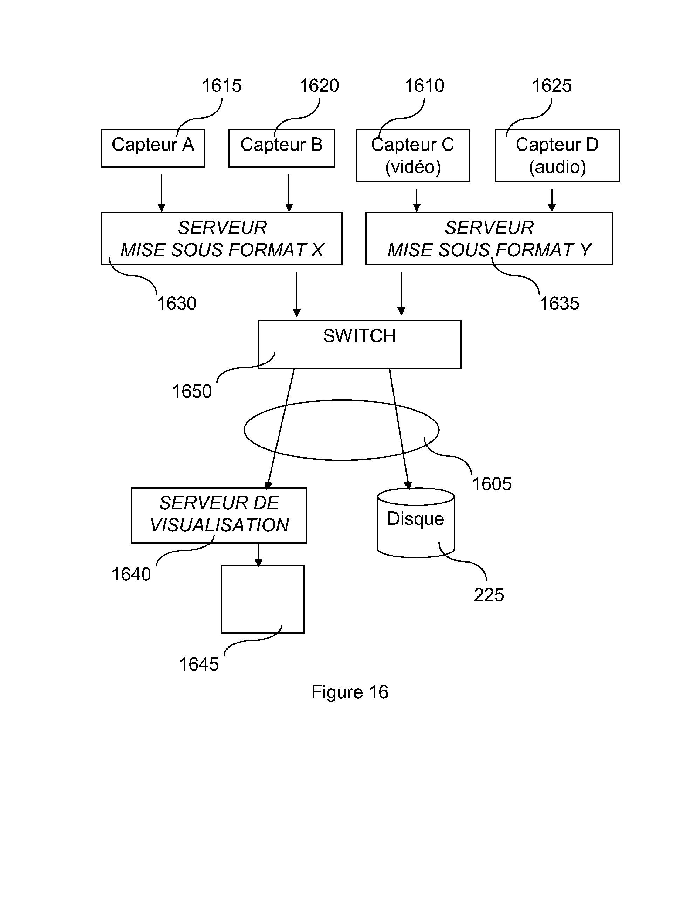

De plus, des variantes sont possibles pour l'architecture globale. Dans une première variante, illustrée en figure 15, mettant en oeuvre un réseau 1505 dédié à la vidéo, les capteurs fournissent directement des données au format fichier à un commutateur (en anglais « switch ») 1515, ce qui implique un certain niveau de complexité des capteurs. Cette architecture pose le problème de temps réel au niveau de la visualisation, gérée par un serveur 1510. La qualité du service et de l'image souhaitée est prise en compte pour le dimensionnement du réseau 1505. En effet, les débits engendrés par les capteurs sont très importants et doivent être gérés sans perte.
a) Dans une deuxième variante, illustrée en figure 16, on met en oeuvre un réseau global 1605 non dédié à la vidéo, réseau dans lequel les capteurs vidéo 1610 sont au même niveau que tout autre capteur IEV 1615, 1620 ou 1625. Dans ce cas, après la capture des données au niveau capteur, ces données sont emballées avec des formats adaptés à chaque application et transitent sur le même réseau, par l'intermédiaire de serveurs 1630 et 1635 et d'un commutateur 1650. Cette architecture pose aussi le problème de temps réel au niveau de la visualisation sur un écran de visualisation 1645, mise en oeuvre par un serveur de visualisation 1640. La qualité du service et de l'image souhaitée est prise en compte pour le dimensionnement du réseau 1605. En effet, les débits engendrés par les capteurs sont très importants et doivent être gérés sans perte.

Dans une troisième variante, on effectue une association des deux variantes précédentes.

## Revendications

1. Dispositif d'acquisition et d'enregistrement de données captées dans un aéronef, comportant :
- une pluralité de sources (202 à 205) de flux de données à enregistrer,
- au moins une source (201) de valeurs de paramètres d'enregistrement datées; et
- des moyens d'enregistrement (220, 230, 235) des données issues des flux de données et des valeurs de paramètre, sur au moins un support d'information non volatile,
**caractérisé en ce que** les moyens d'enregistrement (220, 230, 235) sont adaptés à stocker, dans des fichiers séparés, les données des différents flux de données associées avec des dites valeurs de paramètres d'enregistrement datées, chaque donnée de flux de données étant enregistrée en association avec le temps universel de son acquisition.

2. Dispositif selon la revendication 1, **caractérisé en ce que** les moyens d'enregistrement (220, 230, 235) comportent un moyen de génération (230, 235) de fichiers de synthèse générés au fur et à mesure de l'enregistrement de fichiers représentatifs de données provenant de différentes sources de données, le fichier de synthèse permettant de référencer et relire, de façon synchrone, ces fichiers et contenant des références externes pointant vers chacun les fichiers représentatifs de données provenant des sources de données.

3. Dispositif selon l'une quelconque des revendications 1 ou 2, **caractérisé en ce que** les moyens d'enregistrement (220, 230, 235) sont adaptés à enregistrer de manière dynamique, dans au moins un fichier, les valeurs de paramètres et à enregistrer des descripteurs des paramètres, ainsi que des données relatives à un essai de l'aéronef, par le biais d'une structure de données universelle.

4. Dispositif selon l'une quelconque des revendications 1 à 3, **caractérisé en ce qu'**il comporte un moyen de lecture (220) adapté à générer un fichier de synthèse pour au moins une diffusion de données enregistrées provenant des flux de données le fichier de synthèse permettant de référencer et relire, de façon synchrone, les fichiers contenant des données à diffuser et contenant des références externes pointant vers chacun les fichiers représentatifs de données à diffuser.

5. Dispositif selon l'une quelconque des revendications 1 à 4, **caractérisé en ce qu'**il comporte un moyen de routage (206) des données issues des sources vers des moyens d'enregistrement (220, 230, 235), les moyens d'enregistrement comportant un moyen de datation adapté à compenser les latences de transmission induites par le moyen de routage.

6. Dispositif selon l'une quelconque des revendications 1 à 5, **caractérisé en ce qu'**au moins une source (201) de valeurs de paramètre comporte un convertisseur de valeur temporelle universelle en un code temporel relatif à une source de données de flux.

7. Dispositif selon l'une quelconque des revendications 1 à 6, **caractérisé en ce que** les moyens d'enregistrement (220, 230, 235) sont adaptés à dater les flux de données au moment de l'acquisition en utilisant une horloge interne synchronisée sur une horloge de l'aéronef.

8. Dispositif selon l'une quelconque des revendications 1 à 7, **caractérisé en ce que** les moyens d'enregistrement (220, 230, 235) comportent des moyens d'emballage de chaque flux de données provenant d'une source de flux de données, dans un fichier qui contient des métadonnées statiques identifiant un aéronef, un essai en vol et ladite source de données, les données du flux de données et des informations représentatives de l'instant de capture desdites données.

9. Dispositif selon l'une quelconque des revendications 1 à 8, **caractérisé en ce qu'**il comporte une mémoire tampon dans laquelle, lorsque l'enregistrement n'est pas activé, les flux de données sont stockés et conservés pendant une durée prédéterminée et, lorsque l'enregistrement est démarré, au moins une partie des données mémorisées temporairement sont enregistrées.

10. Dispositif selon l'une quelconque des revendications 1 à 9, **caractérisé en ce que** les flux de données provenant des sources de flux de données sont divisés en segments temporel de durée fixe, les moyens d'enregistrement (220, 230, 235) enregistrant pour chaque segment temporel et chaque paramètre, la valeur la plus récente du paramètre disponible pendant ce segment temporel.

11. Dispositif selon l'une quelconque des revendications 1 à 10, **caractérisé en ce que** les moyens d'enregistrement (220, 230, 235) sont adaptés à enregistrer des fichiers de métadonnées descriptives contenant des valeurs de paramètres répartis dans des segments de durée fixe en fonction de leur date d'acquisition, une seule valeur de paramètre étant enregistrée par paramètre et par segment.

12. Dispositif selon l'une quelconque des revendications 1 à 11, **caractérisé en ce que** les moyens d'enregistrement (220, 230, 235) sont adaptés à diviser les enregistrements en séquences continues, sans interruptions, et homogènes, sans changement de configuration, un nouveau répertoire comportant des nouveaux fichiers pour chaque nouvelle séquence étant généré à chaque fois que l'enregistrement est redémarré ou reconfiguré.

13. Dispositif selon l'une quelconque des revendications 1 à 12**caractérisé en ce que** les moyens d'enregistrement (220, 230, 235) sont adaptés :
- lors d'un essai en vol, à stocker les données en mode « streaming acquisition », mode d'enregistrement dans lequel le fichier est divisé en plusieurs partitions contenant les données d'au moins un flux de données suivies d'un bloc d'information permettant de relire ces lesdites données d'un flux de données et
- au sol, à convertir les données enregistrées pour les enregistrer en mode « fichier », dans lequel le fichier est divisé en une pluralité de blocs, un en-tête et/ou un pied de fichier contenant les informations permettant de relire le fichier et un corps de fichier contenant les données issus des flux de données.

14. Procédé d'acquisition et d'enregistrement de données captées dans un aéronef comportant une pluralité de sources de flux de données à enregistrer, au moins une source de valeurs de paramètres d'enregistrement datées et des moyens d'enregistrement des données issues des flux de données et des valeurs de paramètre, sur au moins un support d'information non volatile,
**caractérisé en ce qu'**il comporte :
- une étape d'enregistrement, pour stocker dans des fichiers séparés des données des différents flux de données et
- une étape d'association, dans chaque fichier, des données enregistrées avec des dites valeurs de paramètres d'enregistrement datées, chaque donnée de flux de données étant enregistrée en association avec le temps universel de son acquisition.

## Patentansprüche

1. Vorrichtung zur Erfassung und Aufzeichnung von in einem Flugzeug erfassten Daten, die Folgendes umfasst:
- mehrere aufzuzeichnende Datenstromquellen (202 bis 205),
- mindestens eine Quelle (201) datierter Aufzeichnungsparameterwerte,
- Aufzeichnungsmittel (220, 230, 235) der aus den Datenströmen hervorgehenden Daten und der Parameterwerte auf mindestens einem nicht flüchtigen Datenträger, **dadurch gekennzeichnet, dass** die Aufzeichnungsmittel (220, 230, 235) angepasst sind, um in getrennten Dateien die Daten der verschiedenen Datenströme, die mit den datierten Aufzeichnungsparametern assoziiert sind, zu speichern, wobei jedes Datenstromdatum in Assoziationen mit der koordinierten Weltzeit seiner Erfassung aufgezeichnet wird.

2. Vorrichtung nach Anspruch 1, **dadurch gekennzeichnet, dass** die Aufzeichnungsmittel (220, 230, 235) ein Mittel zum Erzeugen (230, 235) von Synthesedateien umfassen, die im Laufe der Aufzeichnung von Dateien, die für Daten, die von unterschiedlichen Datenquellen kommen, repräsentativ sind, erzeugt werden, wobei die Synthesedatei es erlaubt, synchron diese Dateien zu referenzieren und neu zu lesen, wobei diese Dateien externe Referenzen enthalten, die zu jeder der Dateien, die für Daten, die von den Datenquellen kommen, repräsentativ sind, zeigen.

3. Vorrichtung nach einem der Ansprüche 1 oder 2, **dadurch gekennzeichnet, dass** die Aufzeichnungsmittel (220, 230, 235) angepasst sind, um dynamisch in mindestens einer Datei die Parameterwerte aufzuzeichnen und Deskriptoren der Parameter sowie Daten bezüglich eines Luftfahrzeugtests über eine universelle Datenstruktur aufzuzeichnen.

4. Vorrichtung nach einem der Ansprüche 1 bis 3, **dadurch gekennzeichnet, dass** sie ein Lesemittel (220) umfasst, das angepasst ist, um eine Synthesedatei für mindestens eine Verteilung aufgezeichneter Daten, die von den Datenströmen kommen, zu erzeugen, wobei die Synthesedatei es erlaubt, synchron die Daten zu referenzieren und neu zu lesen, die zu verteilende Daten enthalten und die externe Referenzen enthalten, die zu jeder der Dateien, die für zu verteilende Daten repräsentativ sind, zeigen.

5. Vorrichtung nach einem der Ansprüche 1 bis 4, **dadurch gekennzeichnet, dass** sie ein Routingmittel (206) der Daten, die aus den Quellen hervorgehen, zu Aufzeichnungsmitteln (220, 230, 235) umfasst, wobei die Aufzeichnungsmittel ein Mittel zum Datieren umfassen, das angepasst ist, um die Übertragungslatenzen, die durch das Routingmittel eingeleitet werden, zu kompensieren.

6. Vorrichtung nach einem der Ansprüche 1 bis 5, **dadurch gekennzeichnet, dass** mindestens eine Parameterwertequelle (201) einen Umwandler von Werten koordinierter Weltzeit in einen Zeitcode bezüglich einer Quelle von Stromdaten umfasst.

7. Vorrichtung nach einem der Ansprüche 1 bis 6, **dadurch gekennzeichnet, dass** die Aufzeichnungsmittel (220, 230, 235) angepasst sind, um die Datenströme im Augenblick der Erfassung zu datieren, indem ein interner Taktgeber verwendet wird, der mit einem Luftfahrzeugtaktgeber synchronisiert ist.

8. Vorrichtung nach einem der Ansprüche 1 bis 7, **dadurch gekennzeichnet, dass** die Aufzeichnungsmittel (220, 230, 235) Mittel zum Packen jedes Datenstroms, der von einer Datenstromquelle kommt, in einer Datei, die statische Metadaten enthält, umfassen, die ein Luftfahrzeug, einen Flugtest und die Datenquelle, die Daten des Datenstroms und Informationen, die für den Augenblick der Erfassung der Daten repräsentativ sind, identifizieren.

9. Vorrichtung nach einem der Ansprüche 1 bis 8, **dadurch gekennzeichnet, dass** sie einen Pufferspeicher umfasst, in dem, wenn die Aufzeichnung nicht aktiviert ist, die Datenströme gespeichert und während einer vorbestimmten Dauer aufbewahrt werden, und, wenn die Aufzeichnung gestartet wird, mindestens ein Teil der vorübergehend gespeicherten Daten aufgezeichnet wird.

10. Vorrichtung nach einem der Ansprüche 1 bis 9, **dadurch gekennzeichnet, dass** die Datenflüsse, die von den Datenstromquellen kommen, in Zeitsegmente mit fixer Dauer geteilt werden, wobei die Aufzeichnungsmittel (220, 230, 235) für jedes Zeitsegment und jeden Parameter den jüngsten Wert des Parameters aufzeichnen, der während dieses Zeitsegments verfügbar ist.

11. Vorrichtung nach einem der Ansprüche 1 bis 10, **dadurch gekennzeichnet, dass** die Aufzeichnungsmittel (220, 230, 235) angepasst sind, um beschreibende Metadatendateien aufzuzeichnen, die Parameterwerte enthalten, die in Segmenten mit fixer Dauer in Abhängigkeit von ihrem Erfassungsdatum verteilt sind, wobei nur ein Parameterwert pro Parameter und pro Segment aufgezeichnet wird.

12. Vorrichtung nach einem der Ansprüche 1 bis 11, **dadurch gekennzeichnet, dass** die Aufzeichnungsmittel (220, 230, 235) angepasst sind, um die Aufzeichnungen in kontinuierliche Sequenzen, ohne Unterbrechungen, die homogen sind, ohne Konfigurationsänderungen zu teilen, wobei ein neues Verzeichnis, das neue Dateien für jede neue Sequenz umfasst, jedes Mal erzeugt wird, wenn die Aufzeichnung neu gestartet oder neu konfiguriert wird.

13. Vorrichtung nach einem der Ansprüche 1 bis 12, **dadurch gekennzeichnet, dass** sie Aufzeichnungsmittel (220, 230, 235) angepasst sind, um:
- bei einem Flugtest die Daten im "Streaming Acquisition"-Modus zu speichern, Aufzeichnungsmodus, bei dem die Datei in mehrere Partitionen geteilt werden, die die Daten mindestens eines Datenstroms enthalten, gefolgt von einem Informationsblock, der es erlaubt, diese Daten in einem Datenstrom neu zu lesen, und
- die aufgezeichneten Daten auf dem Boden umzuwandeln, um sie im "Datei"-Modus aufzuzeichnen, wobei die Datei in mehrere Blöcke geteilt wird, wobei ein Dateikopf- und/oder ein Dateifuß Informationen enthalten, die es erlauben, die Datei neu zu lesen, und einen Dateikörper, der die Daten enthält, die aus den Datenströmen stammen.

14. Verfahren zur Erfassung und zur Aufzeichnung von Daten, die in einem Luftfahrzeug erfasst werden, das mehrere aufzuzeichnende Datenflussquellen umfasst, mindestens eine Quelle datierter Aufzeichnungsparameterwerte und Aufzeichnungsmittel der Daten, die aus den Datenströmen stammen, und der Parameterwerte auf mindestens einem nicht flüchtigen Datenträger,
**dadurch gekennzeichnet, dass** es Folgendes umfasst:
- einen Aufzeichnungsschritt, um in getrennten Dateien Daten der verschiedenen Datenströme zu speichern, und
- einen Schritt des Assoziierens in jeder Datei der aufgezeichneten Daten mit den datierten Aufzeichnungsparameterwerten, wobei jedes Datenstromdatum in Assoziation mit der koordinierten Weltzeit seiner Erfassung aufgezeichnet wird.

## Claims

1. A device for acquiring and recording data captured in an aircraft, comprising:
- a plurality of sources (202 to 205) of data streams to be recorded;
- at least one source (201) of time-stamped recording parameter values; and
- recording means (220, 230, 235) for recording of the data originating from the data streams and from the parameter values on at least one non-volatile information medium,
wherein the recording means (220, 230, 235) are capable of storing the data of the different data streams associated with said time-stamped recording parameter values in separate files, each datum of data streams being recorded in association with the universal time at which it was acquired.

2. A device according to claim 1, wherein the recording means (220, 230, 235) include a means (230, 235) for generating synthesis files generated in step with the recording of files representative of data originating from different data sources, the synthesis file making it possible to reference and read these files synchronously and including external references pointing to each of the files representative of data originating from data sources.

3. A device according to either of claims 1 and 2, wherein the recording means (220, 230, 235) are capable of recording the parameter values dynamically, in at least one file, and of recording parameter descriptors as well as data relating to a test of the aircraft, by virtue of a universal data structure.

4. A device according to any one of claims 1 to 3, comprising a reading means (220) for generating a synthesis file for at least one transmission of recorded data originating from the data streams, the synthesis file making it possible synchronously to reference and read the files containing data to be transmitted and including external references pointing to each of the files representative of data to be transmitted.

5. A device according to any one of claims 1 to 4, comprising a means (206) for routing the data originating from the sources toward recording means (220, 230, 235), the recording means including a time-stamping means capable of compensating for transmission delays induced by the routing means.

6. A device according to any one of claims 1 to 5, wherein at least one source (201) of parameter values includes means for converting a universal time value to a time code pertaining to a source of stream data.

7. A device according to any one of claims 1 to 6, wherein the recording means (220, 230, 235) are capable of time-stamping the data streams at the moment of acquisition by using an internal clock synchronised with an aircraft clock.

8. A device according to any one of claims 1 to 7, wherein the recording means (220, 230, 235) include means for wrapping each data stream originating from a datastream source in a file that includes static metadata identifying an aircraft, a flight test and said data source, the data of the data stream and information items representative of the instant of capture of said data.

9. A device according to any one of claims 1 to 8, wherein it comprises a buffer memory in which, when the recording is not activated, the data streams are stored and kept for a preset duration and, when the recording is started, at least some of the temporarily memorised data are recorded.

10. A device according to any one of claims 1 to 9, wherein the data streams originating from the datastream sources are divided into time segments of set duration, the recording means (220, 230, 235) recording, for each time segment and each parameter, the most recent value of the parameter available during this time segment.

11. A device according to any one of claims 1 to 10, **characterised in that** the recording means (220, 230, 235) are capable of recording files of descriptive metadata containing parameter values distributed in segments of duration set depending on their date of acquisition, a single parameter value being recorded per parameter and per segment.

12. A device according to any one of claims 1 to 11, wherein the recording means (220, 230, 235) are capable of dividing the recordings into continuous interruption-free and homogeneous sequences without changing configuration, a new directory provided with new files for each new sequence being generated whenever the recording is restarted or reconfigured.

13. A device according to any one of claims 1 to 12, wherein the recording means (220, 230, 235) are capable:
- during a flight test, of storing the data in a streaming acquisition mode, a recording mode in which the file is divided into plural partitions containing the data of at least one data stream followed by an information block that makes it possible to read the data of a data stream, and
- on the ground, of converting the recorded data in order to record them in a file mode, in which the file is divided into plural blocks, a file footer and/or header containing the information items allowing the file to be read and a file body containing the data originating from the data streams.

14. A method for acquiring and recording data captured in an aircraft including a plurality of sources of data streams to be recorded, at least one source of time-stamped recording parameter values, and means for recording data originating from the data streams and from the parameter values on at least one non-volatile information medium,
the method comprising:
- a step of storing the data of the different data streams in separate files, and
- a step of associating, in each file, the recorded data with said time-stamped recording parameter values, each datum of data streams being recorded in association with the universal time at which it was acquired.
